# EUROPEAN PATENT APPLICATION

(11) **EP 2 407 232 A1**
(43) Date of publication of application: **18.01.2012**
(21) Application number: 10750603.2
(22) Date of filing: 11.03.2010
(51) Int. Cl.: B01D 53/46, C01B 3/56, C01B 33/04, H01L 21/205

(54) **EXHAUST GAS PROCESSING APPARATUS AND METHOD FOR PROCESSING EXHAUST GAS**

(30) Priority: 12.03.2009 JP 2009059504
(71) Applicant: JX Nippon Oil & Energy Corporation, Chiyoda-ku Tokyo 100-8162 (JP)
(72) Inventor: SAMURA, Ken, Tokyo 1008162 (JP); OHUCHI, Tai, Tokyo 1008162 (JP); ASANO, Tsuyoshi, Tokyo 1008162 (JP); OKABE, Takashi, Tokyo 1008162 (JP)
(74) Representative: Blokland, Arie
(86) International application number: PCT/JP2010/001766
(87) International publication number: WO 2010/103847

(57) **Abstract**

An exhaust gas processing apparatus (10) for processing a mixed gas discharged from a semiconductor manufacturing apparatus (20) is provided with: an adsorption separation unit (40) for separating a monosilane gas that requires abatement and a hydrogen gas that does not require abatement by allowing the mixed gas to pass through and then by mainly adsorbing the monosilane gas among a plurality of types of gases contained in the mixed gas; a heating unit (44) for desorbing the monosilane adsorbed onto the adsorption separation unit (40); a silane gas abatement unit (50) for abating a monosilane gas desorbed from the adsorption separation unit (40); and a hydrogen gas discharge unit (60) for discharging a hydrogen gas separated from the mixed gas by the adsorption separation unit (40).

## Description

### [TECHNICAL FIELD]

The present invention relates to an apparatus and a method for processing an exhaust gas in which a plurality of gaseous species discharged from a semiconductor manufacturing apparatus are mixed.

### [BACKGROUND ART]

Conventionally, a method for manufacturing disilane, which is useful as a semiconductor manufacturing gas and, particularly, as a thin film manufacturing gas, from monosilane has been developed. For example, a method for sending a reactive gas to an adsorption tower filled with an adsorption agent and then circulating unreacted monosilane into a reactor after adsorption separation of disilane is known when manufacturing disilane from monosilane by a discharge method (Patent document No. 1).

In an exhaust gas discharged from a semiconductor manufacturing apparatus, particularly, from a plasma CVD apparatus for forming a silicon thin film used for photovoltaic cells, monosilane that requires abatement, hydrogen that does not require abatement, and fine particles (high order silane) coexist. In a conventional exhaust gas processing apparatus, treatment is performed with use of an abatement apparatus after removing fine particles by a filter and then adding nitrogen to a mixed gas containing remaining monosilane and hydrogen (hydrogen/monosilane=2-100). The amount of the nitrogen to be added is adjusted such that the concentration of the monosilane is 2 percent or less, from a perspective of powder generation (Patent documents No. 2 and No. 3).

[Patent document No. 1] JP 61-186212
[Patent document No. 2] JP 62-134414
[Patent document No. 3] JP 9-239239

### [SUMMARY OF THE INVENTION]

### [PROBLEM TO BE SOLVED BY THE INVENTION]

In an exhaust gas discharged from a semiconductor manufacturing apparatus, for example, from a plasma CVD apparatus for forming a silicon thin film used for photovoltaic cells, a small amount of monosilane that requires abatement and a large amount of hydrogen that does not require abatement may coexist. Processing such a mixed gas that contains a small amount of monosilane and a large amount of hydrogen with use of an abatement apparatus may cause large-scale expansion of not only equipment necessary for monosilane abatement but also an exhaust gas processing apparatus. When abatement of monosilane is carried out by combustion, the amount of consumption of an LPG gas for combustion increases, and energy efficiency of the entire system may thus be lowered.

In this background, a purpose of the present invention is to provide a technique for simplifying an apparatus and steps for processing an exhaust gas discharged from a semiconductor manufacturing apparatus.

### [MEANS TO SOLVE THE PROBLEM]

An exhaust gas processing apparatus according to one embodiment of the present invention is for processing a mixed gas discharged from a semiconductor manufacturing apparatus comprising: an adsorption separation unit configured to separate a first gas that requires abatement and a second gas that does not require abatement by allowing the mixed gas to pass through and then by mainly adsorbing the first gas among a plurality of types of gases contained in the mixed gas; a desorption unit configured to desorb the first gas adsorbed onto the adsorption separation unit; a first gas processing unit configured to process the first gas desorbed from the adsorption separation unit; and a second gas processing unit configured to process the second gas separated from the mixed gas by the adsorption separation unit.

According to the embodiment, the first gas that requires abatement and the second gas that does not require abatement can be separated in advance by the adsorption separation unit, and a proper treatment can thus be performed for each gaseous species by the first gas processing unit and the second gas processing unit. Therefore, the apparatus can be simplified compared to when the mixed gas discharged from the semiconductor manufacturing apparatus is processed integrally. Gas that requires abatement is, for example, a type of gas that cannot be directly discharged to the outside without performing detoxification by some kind of treatment due to the nature of the gas, for example, a degradative treatment or a synthesizing treatment. More specifically, silane and PFC are exemplified. In addition to an apparatus for manufacturing a semiconductor itself, a semiconductor manufacturing apparatus also includes an apparatus that performs a treatment that is necessary for manufacturing a semiconductor or an associated component thereof.

The first gas processing unit may abate the first gas. Since the first gas is separated by the adsorption separation unit, the first gas processing unit can be made compact compared to when the mixed gas is abated integrally.

The first gas processing unit may purify the first gas. Since the first gas is separated by the adsorption separation unit, the first gas processing unit can have a simpler structure compared to when the first gas is directly purified from the mixed gas.

The adsorption separation unit may be provided with an adsorption agent that adsorbs monosilane as the first gas. With this, monosilane can be separated from the mixed gas discharged from the semiconductor manufacturing apparatus, for example, from a plasma CVD apparatus for forming a silicon thin film used for photovoltaic cells.

The second gas processing unit may dilute hydrogen as the second gas and then discharge the diluted hydrogen to the outside. With this, hydrogen contained in the mixed gas discharged from the semiconductor manufacturing apparatus, for example, from the plasma CVD apparatus for forming a silicon thin film used for photovoltaic cells can be discharged to the outside by using a simple method.

The second gas processing unit may purify hydrogen and various noble gases, for example, helium, argon, and the like as the second gas. The hydrogen and the various noble gases as the second gas are separated by the adsorption separation unit; thus, hydrogen and various noble gases of higher purity can be obtained by a simple configuration compared to when hydrogen and various noble gases are purified from a mixed gas.

The desorption unit may desorb the first gas by heating the adsorption separation unit. With this, the first gas and the second gas can be fed to the first gas processing unit without becoming mixed with each other again by controlling timing for the heating.

The desorption unit may desorb the first gas by reducing the pressure of the adsorption separation unit. With this, the first gas and the second gas can be fed to the first gas processing unit without becoming mixed with each other again by controlling timing for the pressure reduction.

Before the adsorption separation unit, a pump for discharging the mixed gas discharged from the semiconductor manufacturing apparatus, a compressor for compressing the mixed gas discharged by the pump and then feeding the compressed mixed gas to a subsequent unit, a gas container for collecting and holding the compressed mixed gas, and a flow rate control unit for controlling the flow rate of the mixed gas supplied from the gas container may be provided.

Another embodiment of the present invention relates to an exhaust gas processing method. This method is an exhaust gas processing method for processing a mixed gas discharged from a semiconductor manufacturing apparatus comprising: separating a first gas that requires abatement and a second gas that does not require abatement by allowing the mixed gas to pass through and then by mainly adsorbing the first gas among a plurality of types of gases contained in the mixed gas onto an adsorption agents; desorbing the first gas adsorbed onto the adsorption agent; abating the first gas desorbed from the adsorption agent; and discharging the second gas separated from the mixed gas to the outside.

According to the embodiment, the first gas that requires abatement and the second gas that does not require abatement can be separated in advance by the adsorption and the separation, and a proper treatment can thus be performed for each gaseous species by the abating and the discharging. Therefore, the treatment can be simplified compared to when the mixed gas discharged from the semiconductor manufacturing apparatus is processed integrally.

### [ADVANTAGE OF THE PRESENT INVENTION]

According to the present invention, an apparatus and steps for processing an exhaust gas discharged from a semiconductor manufacturing apparatus can be simplified.

### [BRIEF DESCRIPTION OF THE DRAWINGS]

Fig. 1 is a system diagram illustrating a scheme of an exhaust gas processing apparatus according to a first embodiment;
Fig. 2 is a schematic diagram illustrating the detailed configuration of a separation unit;
Fig. 3 is a schematic diagram illustrating another detailed configuration of a separation unit;
Fig. 4 is a system diagram illustrating a scheme of the exhaust gas processing apparatus according to a second embodiment;
Fig. 5 is a system diagram illustrating a scheme of the exhaust gas processing apparatus according to a third embodiment;
Fig. 6 is a system diagram illustrating a scheme of the exhaust gas processing apparatus according to a second exemplary embodiment through a fifth exemplary embodiment;
Fig. 7 is a diagram illustrating a breakthrough curve when MS-5A is used as an adsorption agent in the second exemplary embodiment;
Fig. 8 is a diagram illustrating a breakthrough curve when MS-13X is used as an adsorption agent in the second exemplary embodiment;
Fig. 9 is a diagram illustrating a breakthrough curve when active carbon is used as an adsorption agent in the second exemplary embodiment;
Fig. 10 is a diagram illustrating a breakthrough curve when MS-5A is used as an adsorption agent in the third exemplary embodiment;
Fig. 11 is a diagram illustrating a breakthrough curve when MS-13X is used as an adsorption agent in the third exemplary embodiment;
Fig. 12 is a diagram illustrating a breakthrough curve when active carbon is used as an adsorption agent in the third exemplary embodiment;
Fig. 13A is a diagram illustrating time variation of monosilane concentration of an adsorbed gas when absorption and desorption are repeated by a TSA process under the condition (active carbon) of the third exemplary embodiment;
Fig. 13B is a diagram illustrating time variation of monosilane concentration of a desorbed gas when absorption and desorption are repeated by a TSA process under the condition (active carbon) of the third exemplary embodiment;
Fig. 14A is a diagram illustrating time variation of monosilane concentration of an adsorbed gas when absorption and desorption are repeated by a PSA process under the condition (active carbon) of the third exemplary embodiment;
Fig. 14B is a diagram illustrating time variation of monosilane concentration of a desorbed gas when absorption and desorption are repeated by a PSA process under the condition (active carbon) of the third exemplary embodiment;
Fig. 15 is a system diagram illustrating a scheme of the exhaust gas processing apparatus according to a sixth exemplary embodiment;
Fig. 16 is a diagram illustrating a breakthrough curve when MS-5A is used as an adsorption agent in the sixth exemplary embodiment;
Fig. 17 is a diagram illustrating a breakthrough curve when MS-13X is used as the adsorption agent in the sixth exemplary embodiment;
Fig. 18 is a diagram illustrating a breakthrough curve when active carbon is used as the adsorption agent in the sixth exemplary embodiment;
Fig. 19A is a diagram illustrating time variation of monosilane concentration of an adsorbed gas when absorption and desorption are repeated by a PSA process under the condition (active carbon) of the sixth exemplary embodiment; and
Fig. 19B is a diagram illustrating time variation of monosilane concentration of a desorbed gas when absorption and desorption are repeated by a PSA process under the condition (active carbon) of the sixth exemplary embodiment.

### [BEST MODE FOR CARRYING OUT THE INVENTION]

Described below is an explanation of the embodiments of the present invention with reference to figures. In the figures, like numerals represent like constituting elements, and the description thereof is omitted appropriately. A description is given in the following regarding an exhaust gas processing apparatus that is suitable for a mixed gas containing hydrogen as gas that does not require abatement. However, the type of a mixed gas is not limited to this. For example, it is to be understood that, by appropriately selecting an adsorption agent and processing conditions, the exhaust gas processing apparatus of the subject application can also be used for a mixed gas that contains PFC (perfluorocarbon), CHF₃, SF₆, NF₃, or the like as gas that requires abatement and a mixed gas that contains nitrogen or argon as gas that does not require abatement. Typical examples of PFC include CF₄, C₂F₆, C₃F₈, and C₄F₈.

### (First Embodiment)

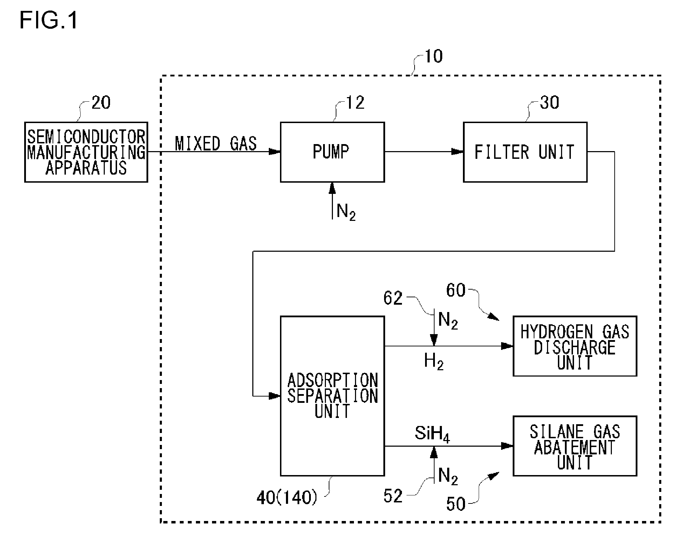

Fig. 1 is a system diagram illustrating a scheme of an exhaust gas processing apparatus according to a first embodiment.

A Semiconductor manufacturing apparatus 20 is not particularly limited. However, the semiconductor manufacturing apparatus 20 includes, e.g., a plasma CVD apparatus for forming a silicon thin film used for photovoltaic cells. More specifically, a photovoltaic cell manufactured by the semiconductor manufacturing apparatus 20 is formed of a combination of compounds that contain at least silicon such as amorphous silicon (a-Si:H), microcrystalline silicon (µc-Si:H), polysilicon (poly-Si), or the like.

A mixed gas (exhaust gas) discharged from the semiconductor manufacturing apparatus 20 includes monosilane that requires abatement, hydrogen, nitrogen, and argon that do not require abatement, and trace impurities. The trace impurities include high order silane, which contains a plurality of silicones (Si) such as disilane and trisilane, PH₃, and B₂H₆ (0.001 to 1 percent each). In the present embodiment, a ratio of hydrogen to monosilane (hydrogen/monosilane) is 2 to 100.

An exhaust gas processing apparatus 10 processes the mixed gas discharged from the semiconductor manufacturing apparatus 20. The exhaust gas processing apparatus 10 is provided with a pump 12, a filter unit 30, an adsorption separation unit 40, a silane gas abatement unit 50, and a hydrogen gas discharge unit 60.

The pump 12 aspirates the mixed gas discharged from the semiconductor manufacturing apparatus 20 and feeds the mixed gas, along with nitrogen, to the filter unit 30. The type of a pump to be used is not particularly limited. However, a dry pump is often used for a semiconductor manufacturing apparatus in general. A purge gas can be introduced to a dry pump for the purpose of keeping airtightness, preventing unnecessary deposition, preventing corrosion inside the pump, improving discharge capability, and the like. The purge gas is not particularly limited. However, an inert gas such as nitrogen and argon is mainly used. The amount of the purge gas to be introduced is not particularly limited. However, about 10 to 50 NL/min per a pump is common.

The filter unit 30 is a particulate trap filter that preferentially removes high order silane. The mixed gas discharged from the semiconductor manufacturing apparatus 20 passes through the filter unit 30. This allows the high order silane to be removed from the mixed gas. A filter to be used is not particularly limited. However, a filter such as a spiral-type filter can be used.

The adsorption separation unit 40 separates monosilane and hydrogen that does not require abatement by allowing the mixed gas to pass through and by adsorbing monosilane contained in the mixed gas by an adsorption agent. As such an adsorption agent, a zeolite, active carbon, silica gel, alumina gel, a molecular sieve such as molecular sieves 3A, 4A, 5A, and 13X, etc., are exemplified.

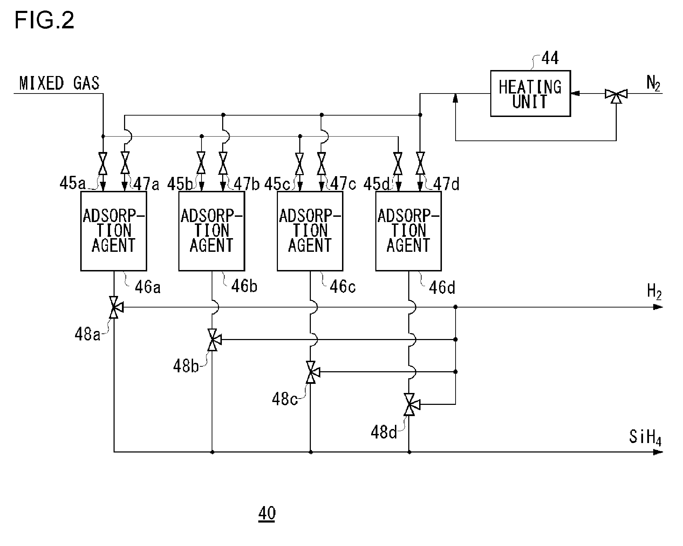

Fig. 2 is a schematic diagram illustrating the detailed configuration of the adsorption separation unit. As shown in Fig. 2, the adsorption separation unit 40 has a heating unit 44, adsorption agents 46a through 46d, adsorption agent switching valves 45a through 45d, carrier gas introduction switching valves 47a through 47d, and three-way valves 48a through 48d.

The type of a carrier gas fed to the heating unit 44 includes nitrogen, hydrogen, and argon. The carrier gas is heated to 40 to 200 degrees Celsius and then fed to each of the adsorption agents 46a through 46d.

The adsorption agents 46a through 46d according to the present embodiment are adsorbing materials that are capable of adsorbing more of monosilane that requires abatement compared to gas that does not require abatement, e.g., hydrogen, nitrogen, and argon. The adsorption agents 46a through 46d may have a structure, e.g., an electric furnace, that allows the temperature to be kept constant on the outside thereof. The temperature is adjusted based on a detection result of a temperature detector (not shown) that is inserted inside the adsorption agents 46a through 46d. Inserting a plurality of temperature detectors allow adsorbent to be kept track of so as to understand adsorption behavior. Differential pressures of the adsorption agents 46a through 46d are monitored by measuring the internal pressures of the adsorption agents 46a through 46d by a plurality of pressure sensors (not shown) so that the respective powdering conditions of the adsorption agents are known.

A detailed description is now given of a method of separating monosilane using an adsorption agent. A carrier gas such as nitrogen that is heated to about 200 degrees Celsius by the heating unit 44 is introduced to each of the adsorption agents 46a through 46d. Discharging has been carried out by a vacuum pump (not shown) until the pressure reaches 0.13 atm (100 Torr) to 1.3*10⁻³ atm (1 Torr), and the pressure is maintained in the condition for about 1 to 100 hours. The respective temperatures of the adsorption agents 46a through 46d are then cooled down to predetermined temperatures (an adsorption agent pretreatment). Then, upon the introduction of a mixed gas having a temperature of 0 to 100 degrees Celsius and a pressure of 0.9 atm (684 Torr) to 9.0 atm (6840 Torr) into the adsorption agents 46a through 46d, monosilane contained in the mixed gas is adsorbed onto the adsorption agents. Thus, a gas having a monosilane concentration of 1.0 percent or less is discharged from the adsorption agents 46a through 46d in the early stage of the introduction. From the aspect of energy efficiency, it is preferred to introduce a mixed gas having a temperature of 30 to 40 degrees Celsius and a pressure of 0.9 atm (684 Torr) to 1.1 atm (836 Torr).

The three-way valves 48a through 48d are controlled such that exhaust passages of the adsorption agents 46a through 46d communicate with the hydrogen gas discharge unit 60. Then, when monosilane of a predetermined concentration is detected by a Fourier transform infrared spectrometer (FT-IR), the passages between the adsorption agents 46a through 46d and the hydrogen gas discharge unit 60 are blocked by the three-way valves 48a through 48d.

The monosilane is being adsorbed onto the adsorption agents at this time. The adsorption separation unit 40 according to the present embodiment desorbs the adsorbed monosilane by, for example, a TSA (Temperature Swing Adsorption) process. More specifically, heating the adsorption agents 46a through 46d to about 40 to 120 degrees Celsius by an electric furnace causes the monosilane to be desorbed from the adsorption agents. Thus, the gas discharged from the adsorption agents 46a through 46d substantially contains the monosilane in a high concentration. The three-way valves 48a through 48d are controlled such that the exhaust passages of the adsorption agents 46a through 46d communicate with the silane gas abatement unit 50.

As described above, by controlling the time at which the mixed gas is introduced and the time at which the adsorption agents are heated, the exhaust gas processing apparatus 10 is capable of feeding a monosilane gas to the silane gas abatement unit 50 in such a manner that the monosilane gas does not become mixed with a hydrogen gas again. Sequential switching of the adsorption agent, into which the mixed gas or the carrier gas is introduced, by using the valves 45a through 45d and 47a through 47d, the adsorption and desorption of the monosilane in the mixed gas can be continuously carried out without any interruption. In other words, when the valve 45a is released while closing other valves and when the three-way valve 48a is switched to an H₂ side, the mixed gas flows into only the adsorption agent 46a, and the monosilane in the mixed gas is adsorbed such that a gas with a reduced monosilane concentration can be obtained at the H₂ side. After the adsorption is carried out for a predetermined period of time, the mixed gas flows into the adsorption agent 46b, and the monosilane in the mixed gas is adsorbed such that a gas with a reduced monosilane concentration can be continuously obtained at the H₂ side, when the valve 45b is released while closing other valves and when the three-way valve 48b is switched to the H₂ side. Concurrently with this, the three-way valve 48a is switched to a SiH₄ side, and the monosilane that is adsorbed onto the adsorption agent 46a by the above-described TSA or PSA (Pressure Swing Adsorption) is desorbed so that a gas containing monosilane in a high concentration can be collected at the SiH₄ side. Repeating these operations alternately for each adsorption agent allows a predetermined gas to be uninterruptedly collected at the H₂ side and the SiH₄ side. Since the adsorption separation unit 40 can separate, in advance, a monosilane gas that requires abatement and a hydrogen gas that does not require abatement, a proper treatment can be performed for each gaseous species by the silane gas abatement unit 50 and the hydrogen gas discharge unit 60. Therefore, the silane gas abatement unit 50 can be made compact compared to when a mixed gas discharged from the semiconductor manufacturing apparatus 20 is processed integrally.

The silane gas abatement unit 50 is provided with an introduction pipe 52 for introducing nitrogen that is used for diluting a monosilane gas as necessary before abatement. The silane gas abatement unit 50 abates the monosilane separated by the adsorption separation unit 40 and then diluted with nitrogen (monosilane of 2 volume percent or less). A method of abating monosilane by the silane gas abatement unit 50 includes abatement by combustion (combustion abatement), abatement by an adsorption agent (dry-type abatement), and the like. In the case of the combustion abatement, a combustion treatment is performed on monosilane by burning an inflammable gas such as an LPG gas in an abatement apparatus with use of a burner. A combustion gas is discharged after dust and the like are removed by a filter. In the case of the dry-type abatement, monosilane is abated by using, for example, a treatment agent that consists primarily of copper oxide.

The hydrogen gas discharge unit 60 may be configured such that collected hydrogen is merely used for a combustion treatment or as a fuel, or is released to the outside after the hydrogen is diluted by introducing nitrogen or oxygen from the introduction pipe 62 so that the concentration of the monosilane in the collected gas becomes an acceptable concentration or below (5 ppmv or less). In the dilution, it is preferred to continue the dilution until the hydrogen concentration becomes an explosion limit or below (4 volume percent or less) for safety reasons. In order to reduce the concentration of the monosilane in the collected gas, a mechanism may be added that is capable of abating the monosilane preferentially before the dilution (not shown). An abatement agent for preferential abatement is not particularly limited. However, the abatement agent includes an oxidation agent, an adsorption agent, etc.

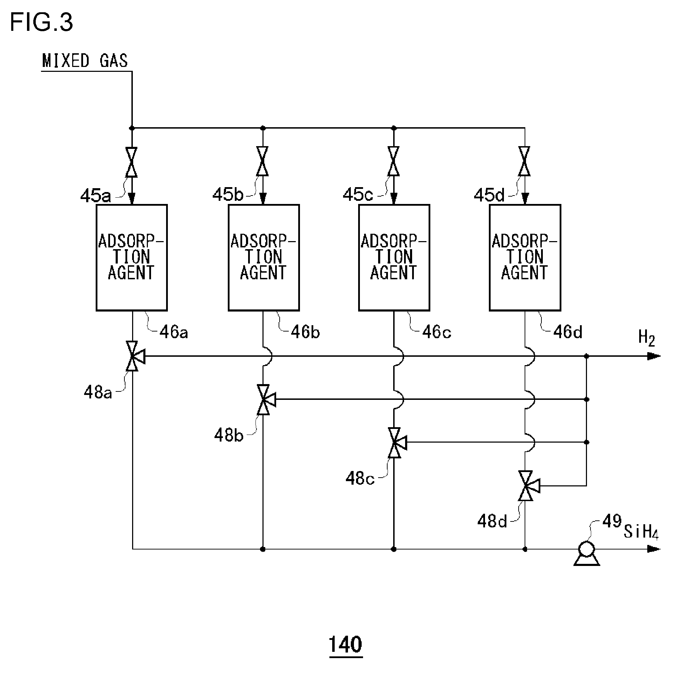

Fig. 3 is a schematic diagram illustrating another detailed configuration of the adsorption separation unit. As shown in Fig. 3, an adsorption separation unit 140 has adsorption agents 46a through 46d, three-way valves 48a through 48d, and a pump 49. Unlike the adsorption separation unit 40 shown in Fig. 2, the adsorption separation unit 140 desorbs the adsorbed monosilane by a PSA (Pressure Swing Adsorption) process. More specifically, reducing the pressures of the adsorption agents 46a through 46d to about 0.5 atm (380 Torr) to 2.0*10⁻³ atm (1.5 Torr) with use of the pump 49 causes the monosilane to be desorbed from the adsorption agents. Thus, the gas discharged from the adsorption agents 46a through 46d substantially contains the monosilane in a high concentration. The three-way valves 48a through 48d are controlled such that the exhaust passages of the adsorption agents 46a through 46d communicate with the silane gas abatement unit 50.

As described above, by controlling the time at which the mixed gas is introduced and the time at which the pressures inside the adsorption agents are reduced, the exhaust gas processing apparatus 10 is capable of sending a monosilane gas to the silane gas abatement unit 50 in such a manner that the monosilane gas does not become mixed with a hydrogen gas again.

The above-explained exhaust gas processing apparatus 10 separates monosilane that requires abatement and hydrogen that does not require abatement by performing adsorption separation, with use of an adsorption agent, on the mixed gas (containing monosilane and hydrogen) obtained after fine particles (high order silane) are removed. After diluted with a gas such as nitrogen or the like, the hydrogen is released to the atmosphere. After diluted with nitrogen, the monosilane is abated by a monosilane abatement unit. The size of abatement equipment can be made small, and an exhaust gas processing apparatus can be even made compact by processing only the monosilane by the monosilane abatement unit. When abatement of the monosilane is carried out by combustion, the amount of consumption of an LPG gas used as fuel can be reduced.

### (Second Embodiment)

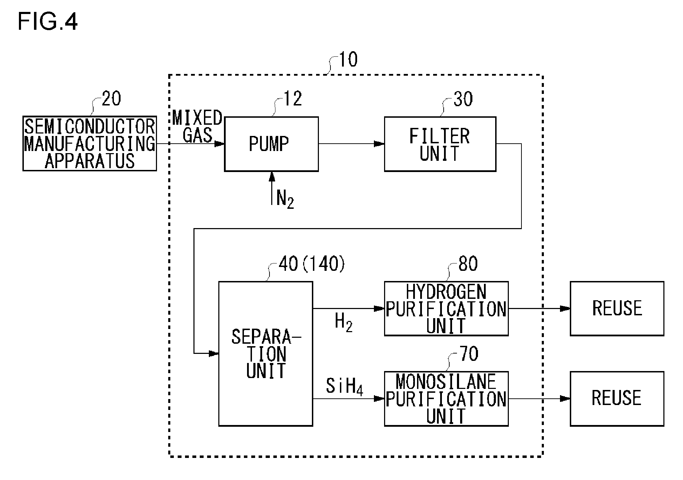

Fig. 4 is a system diagram illustrating a scheme of an exhaust gas processing apparatus according to a second embodiment. The exhaust gas processing apparatus according to the second embodiment has the following features in common with the first embodiment. In other words, the exhaust gas processing apparatus feeds the mixed gas discharged from the semiconductor manufacturing apparatus 20 to the filter unit 30 and then, after removing high order silane with use of the filter unit 30, separates the mixed gas into hydrogen and monosilane by using the adsorption separation unit 40.

The present embodiment is different from the first embodiment in that a monosilane purification unit 70 and a hydrogen purification unit 80 are provided in the present embodiment.

The monosilane purification unit 70 purifies the monosilane separated by the adsorption separation unit 40 with use of an adsorption agent. The adsorption agent includes zeolite. The monosilane purified by the monosilane purification unit 70 can be reused as a raw material. In the present embodiment, a monosilane gas is separated by the adsorption separation unit 40; thus, the monosilane purification unit 70 can have a simpler structure compared to when a monosilane gas is directly purified from a mixed gas. An adsorption agent capable of adsorbing impurities, such as PH₃, B₂H₆, or the like, that are contained in the mixed gas is preferred.

The hydrogen purification unit 80 purifies the hydrogen separated by the adsorption separation unit 40 with use of an adsorption agent. The adsorption agent includes copper oxide, etc. The hydrogen purified by the hydrogen purification unit 80 can be reused as a raw material. In the present embodiment, a hydrogen gas is separated by the adsorption separation unit 40; thus, hydrogen of higher purity can be obtained by the hydrogen purification unit 80 having a simple structure compared to when a hydrogen gas is directly purified from a mixed gas. An adsorption agent capable of also adsorbing impurities, such as PH₃, B₂H₆, or the like, that are contained in the mixed gas is preferred.

In reusing the hydrogen, the hydrogen can be used for different purposes depending on the purity of the purified hydrogen as shown in the following.

When the purity is at least 99.99 percent: hydrogen station, fuel gas for fuel cells, and purified hydrogen
When the purity is at least 99.999 percent: film-forming raw material
According to the present embodiment, monosilane and hydrogen contained in an exhaust gas can be reused while keeping an exhaust gas processing apparatus compact.

### (Third Embodiment)

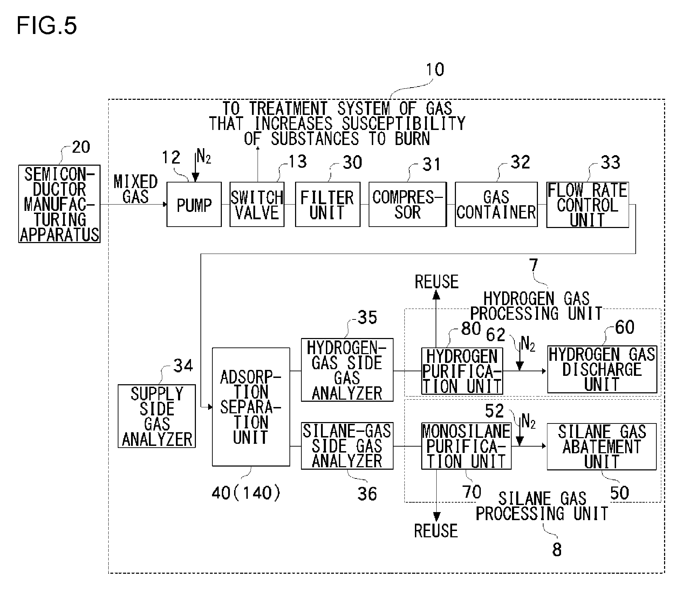

Fig. 5 is a system diagram illustrating a scheme of an exhaust gas processing apparatus according to a third embodiment. The exhaust gas processing apparatus according to the third embodiment has the following features in common with the first embodiment. In other words, the exhaust gas processing apparatus feeds the mixed gas discharged from the semiconductor manufacturing apparatus 20 to the filter unit 30 and then separates the mixed gas into hydrogen and monosilane by using the adsorption separation unit 40 after removing high order silane with use of the filter unit 30. The exhaust gas processing apparatus then feeds the separated gases to the silane gas abatement unit 50 and the hydrogen gas discharge unit 60.

The present embodiment is different from the first embodiment in that the a compressor 31 for compressing a mixed gas discharged by the pump 12 and then feeding the compressed mixed gas to a subsequent unit, a gas container 32 for collecting and holding the compressed mixed gas, a flow rate control unit 33 for controlling the flow rate of the mixed gas supplied from the gas container 32, and a supply side gas analyzer 34 for measuring the component gas concentration of the mixed gas controlled at a constant flow rate by the flow rate control unit 33 are provided before the adsorption separation unit 40 and that a hydrogen-gas side gas analyzer 35 and a silane-gas side gas analyzer 36 for measuring the component gas concentration of the mixed gas fed from the adsorption separation unit 40 are provided.

For example, when operating conditions, particularly, the flow rate and the pressure of the semiconductor manufacturing apparatus 20 change drastically or when exhaust gases from a plurality of semiconductor manufacturing apparatuses with different operating conditions are processed together, the flow rate of a mixed gas supplied to the adsorption separation unit 40 can be controlled to be constant by being provided with the above compressor 31, the gas container 32, and the flow rate control unit 33.

The compressor 31 includes, although not particularly limited, a diaphragm type compressor, a centrifugal compressor, an axial flow compressor, a reciprocating compressor, a twin screw compressor, a single screw compressor, a scroll compressor, a rotary compressor, etc. Among these, a diaphragm type compressor is highly preferred.

Although the operating conditions of the compressor 31 are not particularly limited, it is preferred to operate the compressor 31 such that the temperature of the mixed gas after the compression is at most 200 degrees Celsius, which is the decomposition temperature of monosilane. In other words, it is desired to operate the compressor at a compression ratio of 4.4 or less, in consideration that the mixed gas discharged from the pump 12 is compressed from normal pressure.

The configuration of a compressor used as the compressor 31 is not particularly limited. However, the compressor is preferred to have a configuration where an inverter is also provided or a configuration of a spill-back method where the mixed gas compressed once by the compressor is returned back to the suction side of the compressor, in order to operate the compressor in a stable manner even when the flow rate of the mixed gas supplied to the compressor changes.

When the flow rate or the pressure of the mixed gas discharged from the semiconductor manufacturing apparatus 20 via the pump 12 is unstable or when exhaust gases from a plurality of semiconductor manufacturing apparatuses 20 are processed together, the gas container 32 averages the flow rate and the pressure variation of the mixed gas discharged from each of the semiconductor manufacturing apparatuses 20 by collecting the mixed gas in a tank or the like having sufficient capacity so as to bring the mixed gas with a constant flow rate and pressure to flow into the adsorption separation unit 40 at all times. It is also possible devise a structure so as to provide a function of removing fine particles contained in the mixed gas.

Although not particularly limited, the size of a tank that is used for the gas container 32 is desired to cover the maximum flow rate of an apparatus in the case of a single semiconductor manufacturing apparatus and to cover at least the total value of the maximum flow rates of gases to be supplied to respective semiconductor manufacturing apparatuses in the case of treating a plurality of semiconductor manufacturing apparatuses together.

Although not particularly limited, the pressure inside the tank used for the gas container 32 is desired to be 1 through 100 atm, preferably 3 through 20 atm.

At the time of starting the operation of the apparatus, it is preferable to supply an exhaust gas from the compressor 31 to the gas container 32 and then accumulate the pressure in the gas container 32 while an outlet valve of the gas container 32 is being closed. With this, even when the exhaust gas flow rate of the semiconductor manufacturing apparatus 20 changes drastically, pressure that is sufficient for keeping a flow rate supplied to the adsorption separation unit 40 constant can be maintained, and the amount of gas that can be hold in the gas container 32 can be increased. Thus, the volume of the gas container 32 can be reduced. Further, accumulation of sufficient pressure allows the adsorption pressure of the adsorption separation unit 40 to be set high. Thus, differential pressure that is different from the desorption pressure can be sufficient enough, being advantageous for operation.

The pressure to be accumulated is desired to be 1 to 100 atm, preferably 2 to 50 atm, and more preferably 3 to 20 atm. The adsorption pressure at that time is desired to be 90 percent of less, preferably, 80 percent or less of the accumulated pressure. More specifically, the adsorption pressure when the accumulated pressure is 10 atm is desired to be 9 atm or less, preferably 8 atm or less. Pressure for desorbing the monosilane adsorbed by the above-mentioned PSA method is desired to be reduced to at most a half, preferably, at most one-fourth of the adsorption pressure. More specifically, when the adsorption pressure is 4 atm, the desorption pressure is desired to be 2 atm or less, preferably 1 atm or less.

The flow rate control unit 33 is directed to control the flow rate of the mixed gas to be constant. Although not particularly limited, the control method does not become affected by a pressure change in the mixed gas that is supplied to the flow rate control unit 33, desirably. The control method includes, for example, a mass flow controller, etc.

In order to measure the flow rate and the component gas concentration, particularly the concentration of hydrogen and/or monosilane in the gas, of the mixed gas supplied and discharged to the adsorption separation unit 40, the supply side gas analyzer 34, the hydrogen-gas side gas analyzer 35, and the silane-gas side gas analyzer 36 can be provided. As long as these gas analyzers can measure at least the flow rate of the mixed gas and the concentration of hydrogen and/or the concentration of monosilane in the mixed gas, the method thereof is not particularly limited. For example, a general dry-type or wet-type flowmeter can be used for the flow rate. For the measurement of the hydrogen concentration and/or the monosilane concentration, an FT-IR provided with a gas-flow type sample cell, an online gas chromatograph, or the like can be used.

The results of the above-stated measurement of the flow rate and the hydrogen concentration and/or the monosilane concentration taken by the analyzers can be reflected in operating conditions such as adsorption and desorption conditions, timing at which an adsorption agent is switched, conditions for hydrogen purification and dilution at a hydrogen gas processing unit 7, and conditions for monosilane purification, dilution, and abatement at a silane gas processing unit 8.

For example, when performing an abatement treatment on collected monosilane and then discharging the monosilane by the silane gas processing unit 8, it is necessary to dilute the collected monosilane to a predetermined concentration according to the specifications of an abatement apparatus. In this case, data taken by the silane-gas side gas analyzer 36 can prevent unnecessarily excessive dilution or generation of a problem in the abatement apparatus due to insufficient dilution. Similarly in the hydrogen gas processing unit, data taken by the hydrogen-gas side gas analyzer 35 allows for selection of a proper flow rate of a diluent gas without causing unnecessarily excessive dilution.

When providing the monosilane purification unit 70 to the silane gas processing unit 8 so as to perform a purification treatment on monosilane gas for reuse, analyzing trace impurities in the collected monosilane, in addition to the flow rate and the monosilane concentration, with use of a gas chromatograph or the like by the silane-gas side gas analyzer 36 allows an optimal condition for the purification treatment to be selected and allows, when there are too many impurities, the abatement treatment to be selected while skipping the purification treatment. A valve for switching between lines for an abatement unit and for reuse is preferably provided after the gas analyzer at this time. The same applies when the hydrogen purification unit 80 is provided to the hydrogen gas processing unit 7 so as to perform a purification treatment on the hydrogen gas for reuse.

Preferably, various measurement values are incorporated, and a computation control unit (not shown) for managing a control value is used so as to carry out the above-stated control.

In the semiconductor manufacturing apparatus 20, chemical cleaning is sometimes carried out to remove deposition produced inside a chamber due to film formation. In the chemical cleaning, it is a common practice to perform a plasma treatment under the introduction of gas such as NF₃, F₂, or the like in order to remove a silicon thin film deposited in the chamber. However, since these gases increase the susceptibility of substances to burn, it is necessary to avoid contact with an inflammable gas such as hydrogen and monosilane. Accordingly, it is preferred to provide a switch valve 13 after the pump 12 as shown in Fig. 5 so that an exhaust gas from the chemical cleaning is prevented from getting mixed in a treatment line of a silane gas by switching to a treatment system of gas that increases the susceptibility of substances to burn. The mechanism of the switch valve may be built in the pump.

These embodiments are intended to be illustrative only, and it will be obvious to those skilled in the art that various modifications could be developed based on the knowledge of a skilled person and that such modifications are also within the scope of the present invention.

For example, the exhaust gas processing apparatus according to the first embodiment and the exhaust gas processing apparatus according to the second embodiment may be combined so that either one of monosilane or hydrogen is purified.

A configuration may be implemented such that at least either one of separated monosilane or hydrogen can be purified as necessary by, for example, switching a valve.

A detailed description is given of the present invention base on exemplary embodiments in the following. However, the present invention is not limited to these exemplary embodiments.

### (First Exemplary Embodiment)

Equilibrium adsorption amounts of monosilane, hydrogen, nitrogen, and argon of various adsorbing materials are measured. Table 1 shows equilibrium adsorption amounts of monosilane adsorbed onto various adsorption agents. Table 2 shows equilibrium adsorption amounts of hydrogen adsorbed onto the various adsorption agents. Table 3 shows equilibrium adsorption amounts of nitrogen adsorbed onto the various adsorption agents. Table 4 shows equilibrium adsorption amounts of argon adsorbed onto the various adsorption agents.

**TABLE 1**

| ADSORPTION AGENT SPECIES | EQUILIBRIUM PRESSURE (atm) | TEMPERATURE(°C) | ADSORPTION AMOUNT (mg/g) |
|---|---|---|---|
| MS-4A | 1.0 | 40 | 23 |
| MS-5A | 0.9 | 40 | 85 |
| ACTIVE CARBON | 1.0 | 20 | 153 |
| ACTIVE CARBON | 1.0 | 40 | 136 |
| ALUMINA GEL | 1.1 | 40 | 53 |
| MS-13X | 1.0 | 40 | 92 |
| SILICAGEL | 1.1 | 40 | 16 |

**TABLE 2**

| ADSORPTION AGENT SPECIES | EQUILIBRIUM PRESSURE (atm) | TEMPERATURE(°C) | ADSORPTION AMOUNT (mg/g) |
|---|---|---|---|
| MS-4A | 1.1 | 40 | <0.1 |
| MS-5A | 1.0 | 40 | <0.1 |
| ACTIVE CARBON | 1.0 | 20 | 0.2 |
| ACTIVE CARBON | 1.0 | 40 | <0.1 |
| ALUMINA GEL | 1.0 | 40 | <0.1 |
| MS-13X | 1.0 | 40 | <0.1 |
| SILICA GEL | 1.1 | 40 | <0.1 |

**TABLE 3**

| ADSORPTION AGENT SPECIES | EQUILIBRIUM PRESSURE (atm) | TEMPERATURE(°C) | ADSORPTION AMOUNT (mg/g) |
|---|---|---|---|
| MS-4A | 1.0 | 40 | 4 |
| MS-5A | 1.1 | 40 | 7 |
| ACTIVE CARBON | 0.9 | 20 | 13 |
| ACTIVE CARBON | 1.0 | 40 | 11 |
| ALUMINA GEL | 1.0 | 40 | 6 |
| MS-13X | 1.1 | 40 | 7 |
| SILICA GEL | 1.0 | 40 | 4 |

**TABLE 4**

| ADSORPTION AGENT SPECIES | EQUILIBRIUM PRESSURE (atm) | TEMPERATURE(°C) | ADSORPTION AMOUNT (mg/g) |
|---|---|---|---|
| MS-4A | 1.1 | 40 | <0.1 |
| MS-5A | 1.0 | 40 | <0.1 |
| ACTIVE CARBON | 0.9 | 20 | 0.7 |
| ACTIVE CARBON | 1.0 | 40 | 0.1 |
| ALUMINA GEL | 1.0 | 40 | <0.1 |
| MS-13X | 1.0 | 40 | 0.1 |
| SILICA GEL | 1.1 | 40 | <0.1 |

As is evident from Tables 1 through 4, the various adsorption agents are capable of adsorbing more of monosilane that requires abatement compared to gas that does not require abatement, e.g., hydrogen, nitrogen, and argon.

### (Second Exemplary Embodiment)

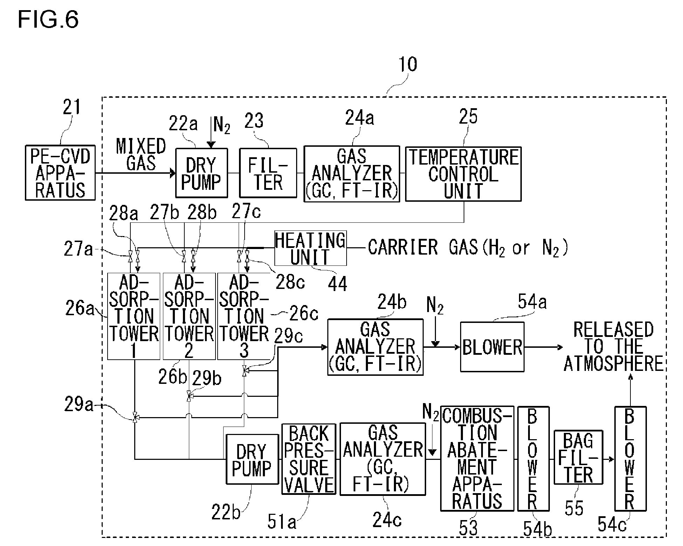

Fig. 6 is a system diagram illustrating a scheme of an exhaust gas processing apparatus according to a second exemplary embodiment through a fifth exemplary embodiment. As shown in Fig. 6, the exhaust gas processing apparatus according to the above-stated exemplary embodiments was connected to a PE-CVD apparatus 21 for manufacturing a silicon thin film photovoltaic cell, which was one of semiconductor manufacturing apparatuses 20, and adsorption separation of an exhaust gas was performed. An adsorption separation unit has a heating unit 44, adsorption towers 26a through 26c, adsorption agent switching valves 27a through 27c, carrier gas introduction switching valves 28a through 28c, and three-way valves 29a through 29c. The type of a carrier gas fed to the heating unit 44 includes nitrogen, hydrogen, and argon. The carrier gas is heated to 40 to 200 degrees Celsius and then fed to each of the adsorption towers 26a through 26c.

The adsorption towers 26a through 26c were filled with respective various adsorption agents, 110 L each. The diameters of the adsorption towers are 400 mm. The following were performed in order to perform a pretreatment of the adsorption agents: the temperatures of the adsorption towers were increased to 200 degrees Celsius while bringing nitrogen to flow at a rate of 10 NL/min as a carrier gas; the nitrogen was then stopped from flowing, and vacuuming was performed by means of a dry pump until the pressures become 10 Torr; after keeping the condition for 2 hours, the temperatures of the adsorption towers were cooled down to a room temperature, and the pressures of the adsorption towers were brought back to a normal pressure by introducing hydrogen as a carrier gas at a rate of 10 NL/min.

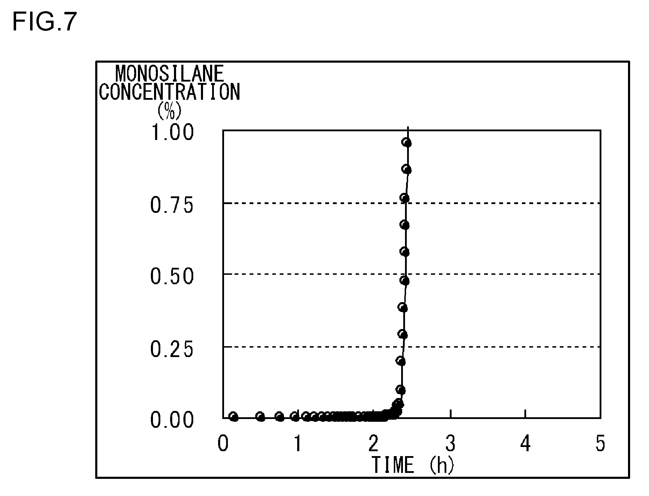

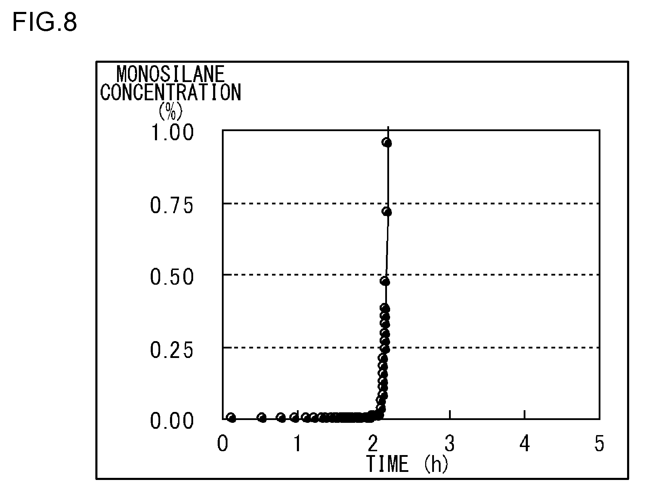

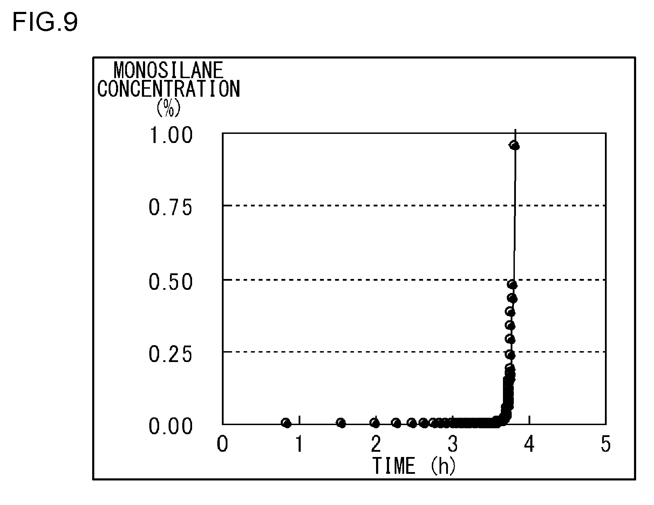

Then, the flow of the hydrogen serving as a carrier gas was stopped, and an exhaust gas from the PE-CVD apparatus 21 was supplied to the adsorption separation unit. Purge nitrogen in a dry pump 22a was not introduced. The total flow rate of the mixed gas supplied to the adsorption separation unit was 63 NL/min, and the hydrogen concentration and the monosilane concentration were 95.2 volume percent and 4.8 volume percent, respectively. The pressure of the supply gas was at normal pressure, and the temperature was 30 degrees Celsius. Breakthrough curves of the respective various adsorption agents that were obtained at that time are shown in Figs. 7-9. Fig. 7 is a diagram illustrating a breakthrough curve when MS-5A was used as an adsorption agent. Fig. 8 is a diagram illustrating a breakthrough curve when MS-13X was used as an adsorption agent. Fig. 9 is a diagram illustrating a breakthrough curve when active carbon was used as an adsorption agent. In any one of the adsorption agents, monosilane contained in the mixed gas was adsorbed onto the adsorption agent, and a condition where the monosilane concentration was 100 ppmv was realized for a certain period of time.

A gas analyzer 24a shown in Fig. 6 is used to measure the flow rate, the hydrogen concentration, and the monosilane concentration of an exhaust gas from the PE-CVD apparatus 21. The exhaust gas that has passed through the gas analyzer 24a is controlled to be at a constant temperature by a temperature control unit 25 and flows into any one of the adsorption towers 26a through 26c. The gas on which monosilane adsorption separation is performed in any one of the adsorption towers 26a through 26c is measured for the flow rate, the hydrogen concentration, and the monosilane concentration in a gas analyzer 24b. The gas obtained after the adsorption separation is diluted with nitrogen based on the measurement results such that the monosilane concentration becomes less than 5 ppmv and such that the hydrogen concentration becomes less than 4 volume percent and then released to the atmosphere by a blower 54a.

### (Third Exemplary Embodiment)

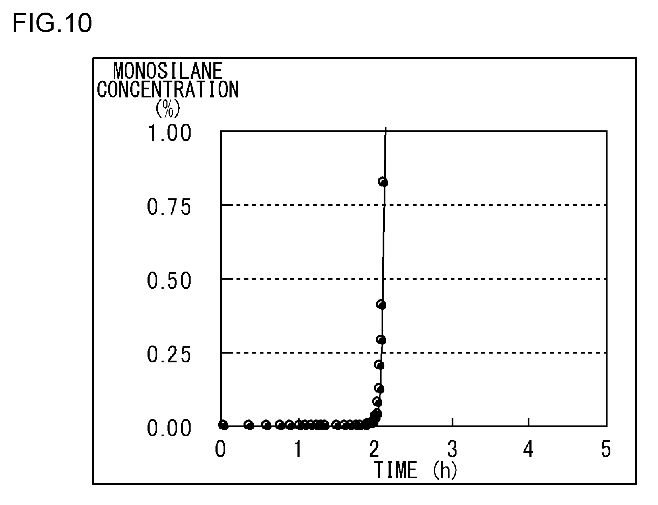

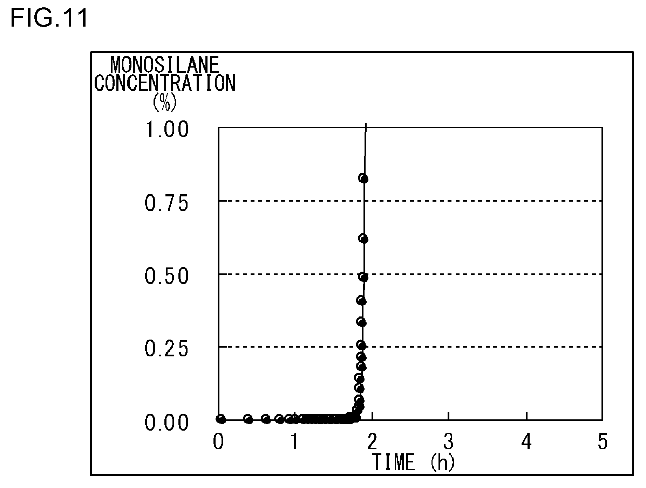

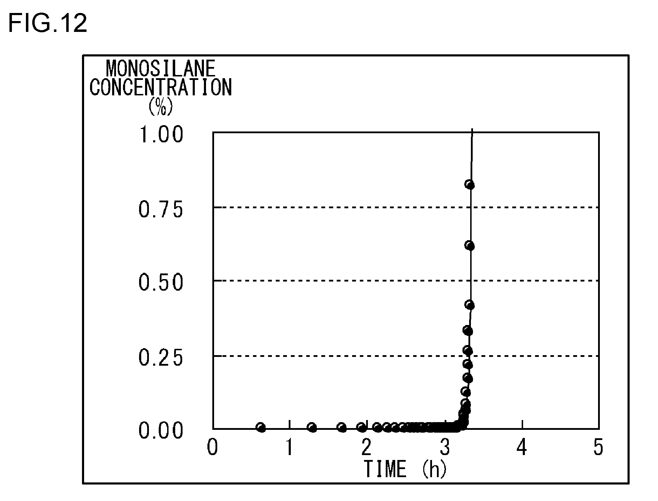

Breakthrough curves of the respective various adsorption agents are shown in Figs. 10-12 that were obtained under the same conditions as those in the second embodiment except that the purge nitrogen in the dry pump 22a was supplied at 10 NL/min. Fig. 10 is a diagram illustrating a breakthrough curve when MS-5A was used as an adsorption agent. Fig. 11 is a diagram illustrating a breakthrough curve when MS-13X was used as an adsorption agent. Fig. 12 is a diagram illustrating a breakthrough curve when active carbon was used as an adsorption agent. Even when nitrogen is mixed in the supply gas, a condition where the monosilane concentration was 100 ppmv was realized for a certain period of time.

### (Fourth Exemplary Embodiment)

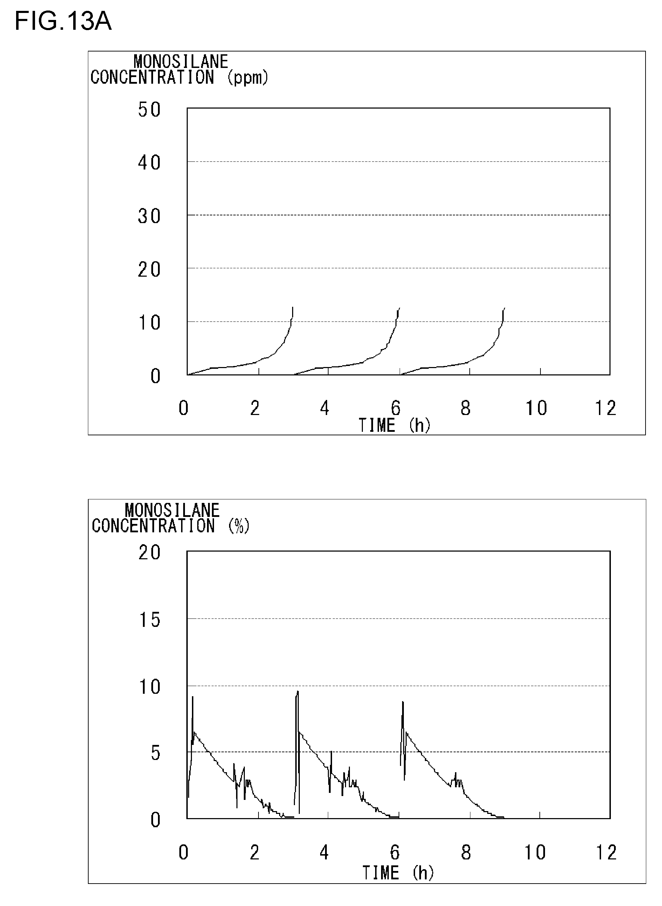

Fig. 13A is a diagram illustrating time variation of the monosilane concentration of an adsorbed gas when absorption and desorption were repeated by a TSA process under the condition (the adsorption agent was an active carbon) of the third exemplary embodiment. Fig. 13B is a diagram illustrating time variation of the monosilane concentration of an desorbed gas when absorption and desorption were repeated by a TSA process under the condition (the adsorption agent was an active carbon) of the third exemplary embodiment. TSA conditions are as shown in the following. Absorption of an exhaust gas was carried out in an adsorption tower 1 (26a) for 3 hours. Then, the supply of the exhaust gas to the adsorption tower 1 (26a) was stopped, and an adsorption tower to which the exhaust gas was supplied was switched to an adsorption tower 2 (26b). Hydrogen was brought to flow into the adsorption tower 1 (26a) at 100 NL/min as a carrier gas, and the temperature of the adsorption tower was raised from 30 degrees Celsius to 80 degrees Celsius at a rate of 1.0 degrees Celsius/min and then kept at 80 degrees Celsius for 130 minutes. Then, the temperature was cooled down to 30 degrees Celsius over a period of 60 minutes, and the temperature was maintained in the condition for 2 hours. Then, the supply of the exhaust gas was started again. In the meantime, absorption of an exhaust gas was also carried out in the adsorption tower 2 (26b) for 3 hours, and an adsorption tower to which the exhaust gas was supplied was then switched to an adsorption tower 3 (26c). The same operation as the one described above was then carried out.
After the flow rate, the hydrogen concentration, and the monosilane concentration are measured in a gas analyzer 24c, the desorbed gas is appropriately diluted with nitrogen based on the measurement results and then abated by combustion by a combustion abatement apparatus 53. Gas that is combusted and then discharged by the combustion abatement apparatus 53 is introduced into a bag filter 55 by a blower 54b and then released to the atmosphere by a blower 54c after foreign substances such as a powder generated at the time of combustion are removed.

### (Fifth Exemplary Embodiment)

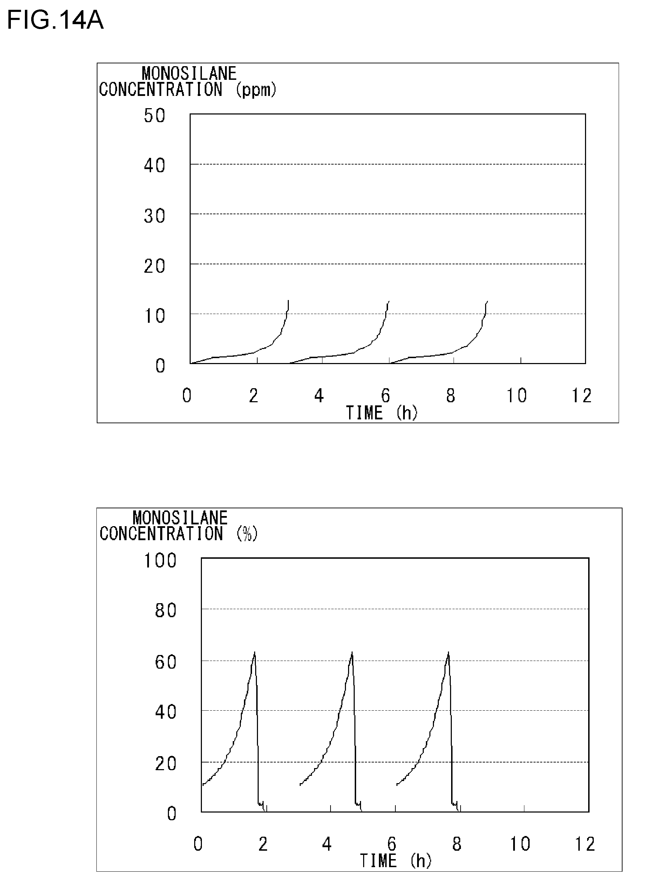

Fig. 14A is a diagram illustrating time variation of monosilane concentration of an adsorbed gas when absorption and desorption were repeated by a PSA process under the condition (the adsorption agent was an active carbon) of the third exemplary embodiment. Fig. 14B is a diagram illustrating time variation of the monosilane concentration of an desorbed gas when absorption and desorption were repeated by a PSA process under the condition (the adsorption agent was an active carbon) of the third exemplary embodiment. PSA conditions are as shown in the following. Absorption of an exhaust gas was carried out in an adsorption tower 1 (26a) for 3 hours. Then, the supply of the exhaust gas to the adsorption tower 1 (26a) was stopped, and an adsorption tower to which the exhaust gas was supplied was switched to an adsorption tower 2 (26b). Then, the pressure of the adsorption tower 1 (26a) was reduced from a normal pressure to -0.1 MPaG at a constant rate over a period of 100 minutes in a dry pump 22b and a back pressure valve 51a, and the pressure is then kept at -0.1 MPa for 80 minutes. Then, hydrogen was introduced at 10 NL/min as a carrier gas, and the pressure of the adsorption tower 1 (26a) was brought back to a normal pressure over a period of 60 minutes. The pressure is then kept in the condition for 2 hours. Then, the supply of the exhaust gas was started again. In the meantime, absorption of an exhaust gas was also carried out in the adsorption tower 2 (26b) for 3 hours, and an adsorption tower to which the exhaust gas was supplied was then switched to an adsorption tower 3 (26c). The same operation as the one described above was then carried out.

### (Sixth Exemplary Embodiment)

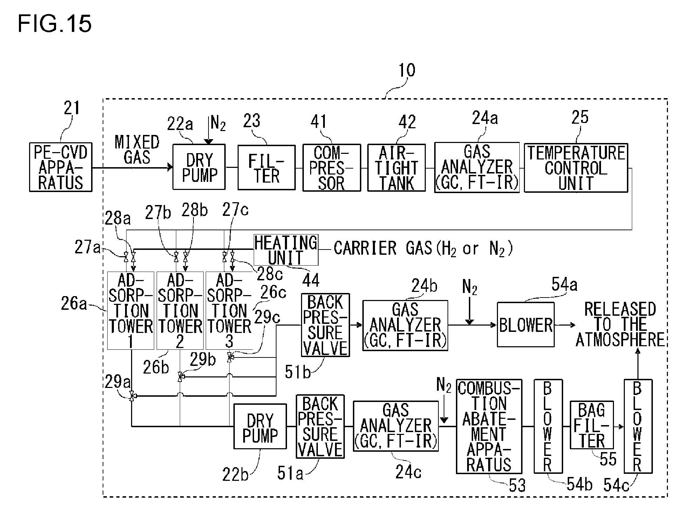

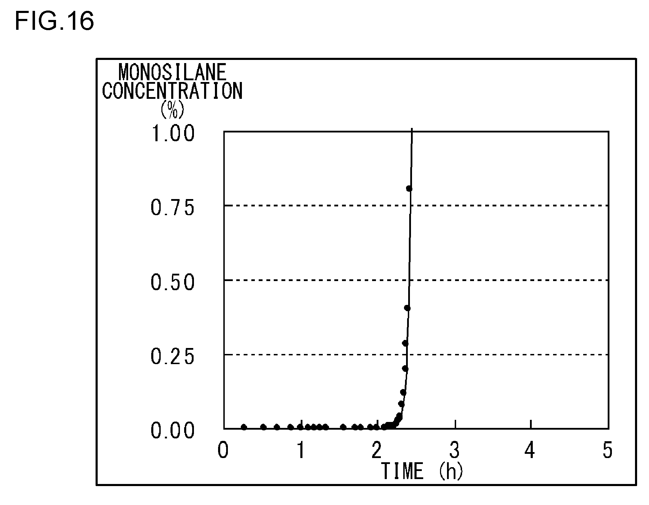

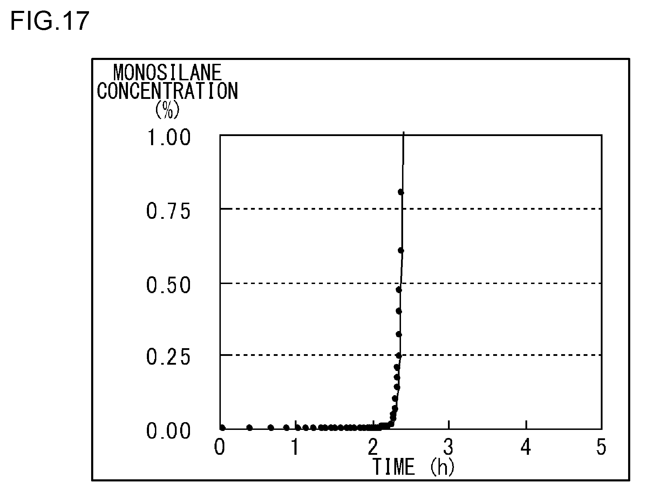

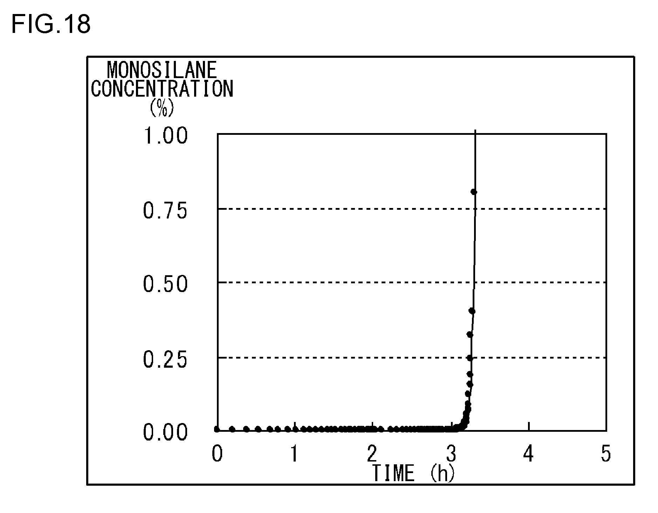

Fig. 15 is a system diagram illustrating a scheme of the exhaust gas processing apparatus according to a sixth exemplary embodiment. As shown in Fig. 15, a compressor 41 and an airtight tank 42 were introduced after a filter 23, and mixed gas was supplied to a adsorption separation unit at high pressure so as to perform an adsorption separation experiment. Conditions thereof were as follows: purge nitrogen in the dry pump 22a was supplied; the total flow rate of the mixed gas supplied to the adsorption separation unit was 250 NL/min; and the hydrogen concentration and the monosilane concentration were 76.0 volume percent and 4.0 volume percent, respectively. The pressure of the supply gas was at 0.4 MPaG, and the temperature was 30 degrees Celsius. Breakthrough curves of the respective various adsorption agents that were obtained at that time are shown in Figs. 16-18. Fig. 16 is a diagram illustrating a breakthrough curve when MS-5A was used as an adsorption agent. Fig. 17 is a diagram illustrating a breakthrough curve when MS-13X was used as an adsorption agent. Fig. 18 is a diagram illustrating a breakthrough curve when active carbon was used as an adsorption agent. In any one of the adsorption agents, monosilane contained in the mixed gas was adsorbed onto the adsorption agent, and a condition where the minimum concentration of monosilane was 100 ppmv was realized for a certain period of time.

### (Seventh Exemplary Embodiment)

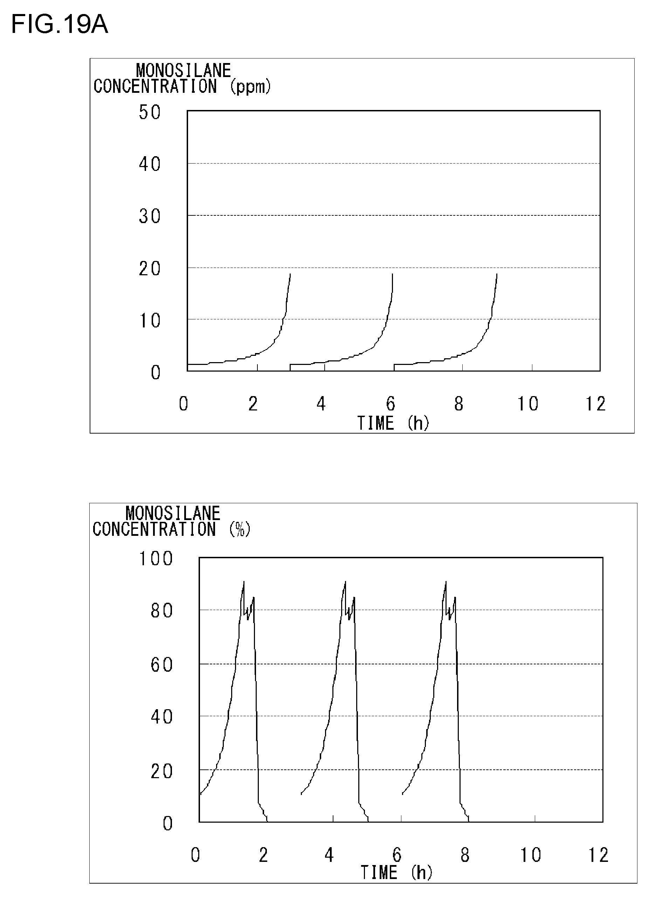

Fig. 19 is a diagram illustrating time variation of the monosilane concentration of an adsorbed gas and a desorbed gas when absorption and desorption were repeated by a PSA process under the condition (active carbon) of the sixth exemplary embodiment. PSA conditions are as shown in the following. Absorption of an exhaust gas was carried out in an adsorption tower 1 (26a) for 3 hours. Then, the supply of the exhaust gas to the adsorption tower 1 (26a) was stopped, and an adsorption tower to which the exhaust gas was supplied was switched to an adsorption tower 2 (26b). Then, the pressure of the adsorption tower 1 (26a) was reduced from a normal pressure to -0.1 MPaG at a constant rate over a period of 100 minutes in the dry pump 22b, and the pressure is then kept at -0.1 MPa for 80 minutes. Then, hydrogen was introduced at 10 NL/min as a carrier gas, and the pressure of the adsorption tower 1 (26a) was brought back to a normal pressure over a period of 60 minutes. The pressure is then kept in the condition for 2 hours. Then, the supply of the exhaust gas was started again. In the meantime, absorption of an exhaust gas was also carried out in the adsorption tower 2 (26b) for 3 hours, and an adsorption tower to which the exhaust gas was supplied was then switched to an adsorption tower 3 (26c). The same operation as the one described above was then carried out.

### [DESCRIPTION OF THE REFERENCE NUMERALS]

- 7: hydrogen gas processing unit
- 8: silane gas processing unit
- 10: exhaust gas processing apparatus
- 12: pump
- 13: switch valve
- 20: semiconductor manufacturing apparatus
- 21: PE-CVD apparatus
- 22a-22b: dry pump
- 23: filter
- 24a-24c: gas analyzer (FT-TR, GC)
- 25: temperature control unit
- 26a-26c: adsorption tower
- 27a-27c: adsorption agent switching valve
- 28a-28c: carrier gas introduction switching valve
- 29a-29c: three-way valve
- 30: filter unit
- 31: compressor
- 32: gas container
- 33: flow rate control unit
- 34: supply side gas analyzer
- 35: hydrogen-gas side gas analyzer
- 36: silane-gas side gas analyzer
- 40: adsorption separation unit
- 41: compressor
- 42: airtight tank
- 44: heating unit
- 45a-45d: valve
- 46a-46b: adsorption agent
- 48a-48b: three-way valve
- 49: pump
- 50: silane gas abatement unit
- 51a-51b: back pressure valve
- 52: introduction pipe
- 53: combustion abatement apparatus
- 54a-54c: blower
- 55: bag filter
- 60: hydrogen gas discharge unit
- 62: introduction pipe
- 70: monosilane purification unit
- 80: hydrogen purification unit
- 140: adsorption separation unit

## Claims

1. An exhaust gas processing apparatus (10) for processing a mixed gas discharged from a semiconductor manufacturing apparatus (20) comprising:
an adsorption separation unit (40) configured to separate a first gas that requires abatement and a second gas that does not require abatement by allowing the mixed gas to pass through and then by mainly adsorbing the first gas among a plurality of types of gases contained in the mixed gas;
a desorption unit configured to desorb the first gas adsorbed onto the adsorption separation unit;
a first gas processing unit configured to process the first gas desorbed from the adsorption separation unit; and
a second gas processing unit configured to process the second gas separated from the mixed gas by the adsorption separation unit.

2. The exhaust gas processing apparatus (10) according to claim 1, wherein the first gas processing unit abates the first gas.

3. The exhaust gas processing apparatus (10) according to claim 1, wherein the first gas processing unit purifies the first gas.

4. The exhaust gas processing apparatus (10) according to any one of claim 1 through claim 3, wherein the adsorption separation unit (40) is provided with an adsorption agent that adsorbs monosilane as the first gas.

5. The exhaust gas processing apparatus (10) according to any one of claim 1 through claim 4, wherein the second gas processing unit dilutes hydrogen and then discharges the diluted hydrogen to the outside as the second gas.

6. The exhaust gas processing apparatus (10) according to any one of claim 1 through claim 4, wherein the second gas processing unit purifies hydrogen as the second gas.

7. The exhaust gas processing apparatus (10) according to any one of claim 1 through claim 6, wherein the desorption unit desorbs the first gas by heating the adsorption separation unit (40).

8. The exhaust gas processing apparatus (10) according to any one of claim 1 through claim 6, wherein the desorption unit desorbs the first gas by reducing the pressure of the adsorption separation unit (40).

9. The exhaust gas processing apparatus (10) according to any one of claim 1 through claim 6 comprising:
before the adsorption separation unit (40), a pump (12) configured to discharge the mixed gas discharged from the semiconductor manufacturing apparatus;
a compressor (31) configured to compress the mixed gas discharged by the pump and feed the compressed mixed gas to a subsequent unit;
a gas container (32) configured to collect and hold the compressed mixed gas; and
a flow rate control unit (33) configured to control a flow rate of the mixed gas supplied from the gas container.

10. An exhaust gas processing method for processing a mixed gas discharged from a semiconductor manufacturing apparatus comprising:
separating a first gas that requires abatement and a second gas that does not require abatement by allowing the mixed gas to pass through and then by mainly adsorbing the first gas among a plurality of types of gases contained in the mixed gas onto the adsorption agents;
desorbing the first gas adsorbed onto the adsorption agent;
abating the first gas desorbed from the adsorption agent; and
discharging the second gas separated from the mixed gas to the outside.
